Europäisches Patentamt

European Patent Office

Office européen des brevets

(11) Publication number: **0 063 416**

**A1**

(12) **EUROPEAN PATENT APPLICATION**

(21) Application number: **82301534.2**

(22) Date of filing: **24.03.82**

(51) Int. Cl.³: **H 01 L 21/76**
**H 01 L 21/78, H 01 L 21/302**

(30) Priority: **27.03.81 GB 8109751**

(43) Date of publication of application:
**27.10.82 Bulletin 82/43**

(84) Designated Contracting States:
**BE CH DE FR IT LI NL SE**

(71) Applicant: **AEI Semiconductors Limited**
**Carholme Road**
**Lincoln LN1 1SG(GB)**

(72) Inventor: **Smith, Trevor**
**10, Mildmay Street**
**Lincoln(GB)**

(74) Representative: **Hoste, Colin Francis et al,**
**Marconi House New Street**
**Chelmsford Essex CM1 1PL(GB)**

(54) Semiconductor device comprising a localised doped region.

(57) When fabricating semiconductor devices from a larger slice of semiconductor material, it is sometimes necessary to produce a region of dopant impurity in which the region extends right through the slice from one major face (7) to the opposite major face (4). Such a region is produced over localised defined areas of the slice and often they correspond to the boundaries of individual devices along which the slice is subsequently cut to produce a number of physically separate devices. A deep but narrow recess (6) is initially formed in one face of the slice and the appropriate impurity is diffused into the surface of the recess and the opposite unrecessed face until the two diffusions meet.

Fig.l.

## Improvements in or relating to semiconductors

This invention relates to semiconductors and is particularly applicable to slices of doped semiconductor material in which a localised doped region of the semiconductor is required to extend from one major face of the slice to the opposite face. It is difficult to produce a very localised doped region by diffusion of an appropriate impurity, since the lateral extent of the diffused region increases markedly as the depth of diffusion increases, and the diffusion must often be very deep indeed if it is to extend right through the thickness of a slice. Accordingly, this invention seeks to provide an improved semiconductor and a method of processing it.

According to a first aspect of this invention, a method of processing a slice of semiconductor material includes the steps of forming a deep, but narrow recess in one major face of the slice by means of a saw cut, with the recess extending towards the opposite major face; and subsequently diffusing a dopant impurity into the surface of the recess so formed until a continuous region of said dopant extends between said major face.

The dopant may be p-type or n-type depending on the nature of the semiconductor slice into which it is diffused. Generally the semiconductor slice itself will not be intrinsic in nature, but will already possess an n-type or p-type dopant. In this case a dopant of the opposite nature is diffused into the surface of the recess.

The concentration of the diffused dopant will not, of course, be uniform throughout the thickness of the slice, but will reduce from a high concentration at the surface at which it is introduced into the semiconductor material. It may be that a relatively shallow layer of the dopant is also introduced into the slice from said opposite major face. This is a typical requirement for high power semiconductor devices and in this case a continuous region of said dopant will extend between two said major faces when the said diffusion from said one major face meets said shallow layer.

Preferably said shallow layer of dopant is formed by diffusion at the same time as the dopant is diffused into the surface of the recess.

Preferably the recess is in the form of an elongate groove extending right across said one major face of the slice, and conveniently it is produced by a saw cut of controlled and constant depth, although it could be produced by a laser cutting technique.

It is customary to produce a number of identical semiconductor devices from a single large slice of semiconductor material by processing simultaneously small localised areas of the slice, and subsequently dividing the slice into physically separate portions so that each small localised area then constitutes a separate semiconductor device, such as a transistor or thyristor.

Preferably again two sets of straight elongate grooves are initially formed in said one major face, with the two sets being mutually at right angles so that together they define a regular array of rectangular islands of localised areas of the semiconductor material.

According to a second aspect of this invention a semiconductor device is made utilising the processing steps set out above.

In order to produce a large number of individual semiconductor devices it is desirable to form a grid network of localised diffusions which connect the two major faces of a slice of semiconductor material. The grid network defines the plurality of individual devices. To avoid additional processing steps this diffusion is preferably made at the same time as the diffusion which forms the main blocking junctions of the device. In a thyristor two main block junctions are required. The above mentioned recess is made in the surface of the slice which is opposite to that surface in which subsequent planar processing is performed. It is difficult to perform planar processing, such as photolithographic masking satisfactorily on a deeply cut surface. In order to accurately align the position of the diffusions and other processes on both opposite faces of the semiconductor slice, two optical masks which preferably carry an identical simple rectangle grid pattern, are first accurately aligned with each other. They are then withdrawn apart slightly to allow the slice to be inserted between them whilst maintaining the original alignment. These masks are then used to produce reference surface indentations, which are used as registration marks for subsequent processing of each major face of the slice.

The invention is further described by way of example with reference to the accompanying drawing in which,

Figure 1 shows a section view through part of a slice of semiconductor material, and

Figure 2 shows a schematic plan view of the whole slice.

Referring to the drawing, a slice 1 of crystalline silicon is initially provided during manufacture with a uniformly distributed n-type dopant. Conveniently, the n-type dopant is introduced at the time the silicon is purified during manufacture, and prior to the slice being formed from a large cylindrical ingot of silicon.

A continuous film of silicon dioxide about 1 $\mu$M thick is grown all over the surface of the silicon slice 1. The silicon dioxide facilitates subsequent photolithographic processing, as photoresist does not adhere well to silicon itself. A thin layer of photosensitive photoresist material is spun onto both faces of the slice using standard photoresist techniques. Two identical optical masks carrying grid networks are carefully aligned with each other and the slice inserted between them. By exposing both layers of photoresist to ultra violet light through these masks, windows are opened in the photoresist layers which when developed correspond to the grid networks.

Using the patterned photoresist layer so formed, as an etch mask, the exposed regions of silicon dioxide on both faces of the silicon slice are etched away. The etchant used is a mixture of 5 parts by volume ammonium fluoride to 1 part hydrofluoric acid (48%), and this etches the silicon dioxide at typically a rate 0.2 $\mu$M per minute. It does not etch the underlying silicon.

The silicon exposed at the bottom of the windows in the silicon dioxide is indented to a shallow depth of only 1 to 2 $\mu$M by etching the silicon by a standard etchant, such as one consisting of 10 parts by volume of nitric acid (70%) to 1 part hydrofluoric acid (40%). This etches the silicon at a rate of about 10 to 12 µM per minute. The photoresist layer is now removed.

Subsequently deep grooves 6 are formed in one face by means of a thin bladed high speed saw.

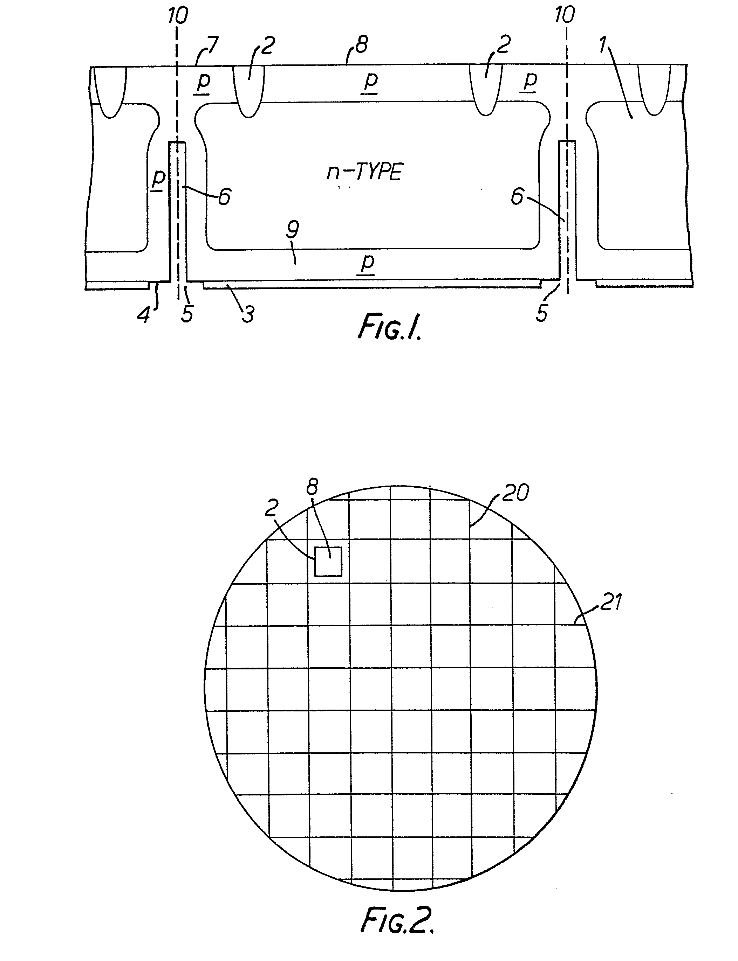

These grooves extend in straight lines across the surface 4, and also correspond to the sets of lines 20 and 21 shown in Figure 2. The depth of the grooves is carefully controlled, and is held substantially constant across the entire surface of the slice. The two sets of grooves form a regular array of individual island areas of semiconductor material at the face 4.

The saw creates considerable surface damage to the slice and this damage or roughness is etched away by means of a conventional etchant.

Before the application of this etchant, the face of the silicon slice opposite the saw cuts is protected by an etchant resist layer, such as photoresist or black wax. This protects the shallow indented reference grid formed previously. The damage to the silicon surface can be etched away using the same etchant referred to above, which was used to form the reference grid. Typically about 20 µM of silicon is removed from the saw cut, but the surrounding surface of the slice is protected from the etchant by the silicon dioxide layer 3 which is still present, and which is itself etched away only very slowly, i.e. at a rate of about 0.25 µM per minute. The width of the original groove formed by the saw might be typically about 100 µM and the use of the etchant will increase this width by possibly another 20 µM.

The etch resistant layer and all the silicon dioxide is removed.

Subsequently the whole slice is placed in a suitable diffusion furnace and receives an all-over diffusion of p-type dopant into both faces and in the saw cut. The p-type diffusion itself may be of a quite conventional nature. The p-type dopant diffuses not only into the two major faces 4 and 7 of the slice 1, but also into the exposed surface of the grooves 6. The diffusion of the p-type dopant continues until the dopant entering the semiconductor material from the surface of the groove 6 meets that entering from the other major face 7. At this point a continuous region of p-type dopant extends between the two major surfaces. In Figure 1, this situation is shown existing at two individual points, but, in practice, as is shown in Figure 2, the slice 1 is of relatively large lateral area and all grooves are, of course, processed simultaneously.

A further diffusion, which is shallow as compared with the depth of the previous p-type diffusion, is now made with an n-type dopant. In a thyristor this n-type diffusion forms the n-emitter and gate and any emitter shorting points. These n-type regions are not shown in Figure 1, but would be formed at a central region 8 using an oxide mask which is aligned to the shallow indented grid network referred to previously.

The electrically insulating regions 2 are now formed so as to electrically isolate the central region 8 of the p-type material from the remaining surrounding p-type layer 9. This is shown in Figure 2 for just one of the island areas for simplicity of illustration but in practice all island areas are treated simultaneously in an identical manner. This can be conveniently achieved by etching a relatively wide shallow recess in the upper major face of the slice, so that the depth of the recess penetrates through the p-type surface layer into the central n-type region. If necessary the exposed p-n junctions can be protected by means of a surface passivation layer, and this will normally be the case. In the drawing, the recesses are shown completely filled with a suitable insulating passivation material, but a thin layer which coats the surface of the recess could be used. The material could be of semi-insulating polycrystalline silicon film or an inert gas.

The p-n region surrounded by the groove 2 constitutes the forward blocking junction of a thyristor. The p-n junction outside this groove, but within the saw cut 6 constitutes the reverse blocking junction.

Subsequent processing can be performed on the upper surface which carries the insulating recesses 2, since no exposed p-n junctions exist on the lower face 4 and in particular no p-n junctions extend to the edges of the individual dice.

Consequently, subsequent processing can be in accordance with conventional planar techniques. The use of the electrically insulating recesses 2 means that the central p-type region 8 can be operated at voltages which differ considerably from those applied to the remaining p-type layer 9. This provides significant practical advantages and considerably eases subsequent processing difficulties. High current ohmic contacts can be applied as necessary to the major faces 4 and 7.

Subsequently, the slice 1 is sawn into separate small dice by cutting along the broken lines 10 - these cuts correspond to the sets of lines 20 and 21. The effect of this is to produce individual small semiconductor devices in which a central n-type region is completely enclosed by means of a surrounding p-type surface layer.

CLAIMS:

1. A method of processing a slice of semiconductor material including the steps of forming a deep, but narrow recess in one major face of the slice by means of a saw cut, with the recess extending towards the opposite major face; and subsequently diffusing a dopant impurity into the surface of the recess so formed until a continuous region of said dopant extends between said major face.

2. A method as claimed in claim 1 and wherein said semiconductor material is initially p-type or n-type, and said dopant is n-type or p-type respectively, so that a dopant of the opposite nature is diffused into the surface of the recess.

3. A method as claimed in claim 1 or 2 and wherein a relatively shallow layer of the dopant is also introduced into the slice from said opposite major face.

4. A method as claimed in claim 3 and wherein said shallow layer of dopant is formed by diffusing at the same time as the dopant is diffused into the surface of the recess.

5. A method as claimed in claim 1 and wherein the recess is in the form of an elongate groove extending right across said one major face of the slice.

6. A method as claimed in claim 5 and wherein the elongate groove is produced by a saw cut of controlled and constant depth.

7. A method as claimed in claim 5 or 6 and wherein two sets of straight elongate grooves are initially formed in said one major face, with the two sets being mutually at right angles so that together they define a regular array of rectangular islands of localised areas of the semiconductor material.

*FIG.1.*

*FIG.2.*

0063416

European Patent
Office

EUROPEAN SEARCH REPORT

Application number

EP 82 30 1534

## DOCUMENTS CONSIDERED TO BE RELEVANT

| Category | Citation of document with indication, where appropriate, of relevant passages | Relevant to claim | CLASSIFICATION OF THE APPLICATION (Int. Cl ³) |
|---|---|---|---|
| X | DE-A-2 306 842 (SIEMENS) *Claims 1-4; figures 2-6* --- | 1-7 | H 01 L 21/76<br>H 01 L 21/78<br>H 01 L 21/302 |
| X | FR-A-2 410 363 (LE SILICIUM SEMICONDUCTEUR SSC) *Claims 1-7; figure 3* ----- | 1-6 | |

TECHNICAL FIELDS
SEARCHED (Int. Cl ³)

H 01 L

The present search report has been drawn up for all claims

| Place of search | Date of completion of the search | Examiner |
|---|---|---|
| THE HAGUE | 09-07-1982 | VANCRAEYNEST F.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82